# EUROPÄISCHE PATENTSCHRIFT

(11) **EP 2 104 750 B1**
(45) Veröffentlichungstag und Bekanntmachung des Hinweises auf die Patenterteilung: **03.05.2017**
(21) Anmeldenummer: 07857054.6
(22) Anmeldetag: 21.12.2007
(51) Int. Cl.: C23C 4/134, H05H 1/42, H05K 3/14, H05K 3/10

(54) **VERFAHREN UND VORRICHTUNG ZUM AUFSPRITZEN EINER LEITERBAHN**
METHOD AND DEVICE FOR SPRAYING A CONDUCTIVE LINE
PROCÉDÉ ET DISPOSITIF POUR PULVÉRER UNE PISTE CONDUCTRICE

(30) Priorität: 23.12.2006 DE 102006061435
(43) Veröffentlichungstag der Anmeldung: 30.09.2009
(73) Patentinhaber: Leoni AG, 90402 Nürnberg (DE)
(72) Erfinder: SÜSS-WOLF, Robert, 90473 Nürnberg (DE); DE PAOLIS, Marco, 90763 Fürth (DE); GEIST, Dieter, 91301 Forchheim (DE); REICHINGER, Gerhard, 91126 Rednitzhembach (DE); PIEPER, Gerard, 03222 Lübbenau (DE)
(74) Vertreter: FDST Patentanwälte
(86) Internationale Anmeldenummer: PCT/EP2007/011339
(87) Internationale Veröffentlichungsnummer: WO 2008/077608

(56) Entgegenhaltungen:
- WO-A-2005/031026
- WO-A-2006/118813
- DE-A1- 19 807 086
- US-A- 3 198 932
- US-A- 5 766 693
- US-A1- 2004 055 153
- US-A1- 2006 258 055
- US-B1- 7 045 738
- HOUBEN J M: "SOME REMARKS ON PLASMA SPRAYING POWDER INJECTION TECHNIQUES", 8TH INTERNATIONAL THERMAL SPRAYING CONFERENCE. PROCEEDINGS,, 28 September 1976 (1976-09-28), pages 68-77, XP007920767,

## Beschreibung

Die Erfindung betrifft ein Verfahren sowie eine Vorrichtung zum Aufspritzen einer Bahn, insbesondere einer Leiterbahn auf ein Substrat mit den Merkmalen des Oberbegriffs des Anspruchs 1 bzw. des Anspruchs 13.

Ein derartiges Verfahren ist beispielsweise zu entnehmen aus der WO2005/031026 A1. Darin ist ein Plasmaspritzverfahren beschrieben, bei dem in einer Spritzlanze ein Niedertemperaturplasma erzeugt und ein Plasmastrahl vorgegebener Breite auf ein Substrat gerichtet wird. Über eine Pulverzuführung wird der Spritzlanze geeignetes Pulver pneumatisch zugeführt.

Zur Erzeugung von Bahnen, insbesondere von Leiterbahnen auf einem insbesondere isolierenden Substrat ist die Verwendung von unterschiedlichsten Spritzverfahren bekannt. So wird beispielsweise in der EP 1 363 811 B1 ein Verfahren zum Aufspritzen einer Leiterbahn auf ein Substrat mit Hilfe des Flammspritzens und/oder des Kaltgasspritzens beschrieben. Daneben wird als Spritzverfahren beispielsweise auch Plasmaspritzen eingesetzt. Aus der DE 103 20 379 A1 ist die Aufbringung einer Heizleiterbahn insbesondere mittels des Flammspritzens für unterschiedlichste Anwendungen zu entnehmen.

In der US 5 766 693 A sowie der DE 198 07 086 A1 sind jeweils Plasmaspritzverfahren beschrieben, bei denen einem Plasmastrahl nach dessen Austritt aus einer Lanzenöffnung seitlich unter einem Winkel ein Pulverstrom zugeführt wurd.

Allgemeine Grundlagen zum Plasmaspritzen sind beispielsweise zu entnehmen aus Houben J M: "Some remarks on plasma spraying powder injection techniques" 8th international thermal spraying conference proceedings, 28. Septeber 1976,(1976 -09-28), Seiten 68-77.

Es hat sich jedoch gezeigt, dass die bekannten Spritzverfahren für einen kostengünstigen, flexiblen Einsatz zur Erzeugung insbesondere von elektrischen Bauteilen mit der aufgespritzten Leiterbahn teilweise aufwändig und daher nicht mehr wirtschaftlich sind.

In der Leiterplattentechnologie werden unterschiedliche Spritzverfahren regelmäßig eingesetzt, jedoch üblicherweise unter Verwendung einer Spritzmaske, wobei die Spritzmaske das aufzubringende Leiterbahnmuster zeigt. Dieses Verfahren bietet sich nur bei hohen Stückzahlen an. Insbesondere sind bei den Verfahren mit Maskenunterstützung keine flexiblen Leiterbahnverläufe möglich.

Auch hat sich gezeigt, dass die Verbindung zwischen den aufgespritzten Partikeln und dem Substrat teilweise mangelhaft ist oder zumindest in Abhängigkeit der gewählten Materialpaarungen starken Schwankungen unterworfen ist. Auch die Qualität der aufgespritzten Bahn ist stark vom Material des Substrats abhängig.

Bei den Spritzverfahren werden die aufzubringenden Teilchen erhitzt und/oder stark beschleunigt. Aufgrund der relativ großen thermischen und/oder kinetischen Energie der Teilchen wird insbesondere bei sehr dünnen Substraten im Bereich kleiner 1 mm teilweise ein unerwünschtes Durchschlagen des Substrats, zumindest ein Beschädigen des Substrats hervorgerufen.

Um eine sichere und dauerhafte Verbindung des Substrats mit den aufgespritzten Partikeln zu gewährleisten, ist weiterhin oftmals eine Vorbehandlung des Substrats erforderlich. Teilweise ist auch vorgesehen, dass vor dem Aufbringen der eigentlichen Bahn eine Keimschicht aufgebracht wird.

Der Erfindung liegt die Aufgabe zugrunde, das Aufspritzen einer Bahn, insbesondere einer Leiterbahn, auf einem Substrat zu ermöglichen, bei dem die Qualität der aufgespritzten Bahn möglichst unabhängig von dem verwendeten Material des Substrats ist und der Verlauf der Leiterbahn frei gewählt werden kann.

Die Aufgabe wird gemäß der Erfindung gelöst durch ein Verfahren mit den Merkmalen des Anspruchs 1. Danach wird insbesondere eine Leiterbahn auf ein Substrat mit Hilfe einer sich in Längsrichtung erstreckenden Spritzlanze aufgebracht. Diese wird hierbei mit einer Relativgeschwindigkeit relativ zu dem Substrat bewegt, um somit maskenfrei und ohne Begrenzungen den Verlauf der Leiterbahn frei wählen zu können. Das Spritzverfahren beruht hierbei auf einem atmosphärischen, kalten Plasmaspritzen, bei dem der Spritzlanze ein ionisierbares Gas zugeführt wird, welches durch einen in der Spritzlanze erzeugten Lichtbogen ionisiert wird. Hierbei entsteht ein kaltes Plasma mit einer Plasmatemperatur vorzugsweise kleiner 2500 K. Gleichzeitig wird in die Spritzlanze mit Hilfe eines Trägergasstromes ein Pulver eingebracht, welches vom Plasma in Richtung zu einer stirnendseitigen Austrittsöffnung der Spritzlanze mitgeführt wird, dort austritt und anschließend auf dem Substrat auftritt und dort die Leiterbahn ausbildet.

Durch Verwenden eines kalten Plasmas mit einer Plasmatemperatur kleiner 3000 K, vorzugsweise kleiner 2500°K und insbesondere kleiner 2000 K ist zum einen der technologische Aufwand für das Spritzverfahren sehr gering und mit nur geringen Investitionskosten verbunden. Gleichzeitig erfolgt durch das kalte Plasma ein vergleichsweise geringer Energieeintrag in das aufzubringende Material, so dass dieses auf das Substrat sehr schonend aufgebracht wird. Selbst dünne Substratschichten kleiner 1 mm bis hin zu wenigen µm werden daher beim Spritzverfahren nicht zerstört. Dadurch eignet sich dieses Verfahren insbesondere auch zum Aufspritzen von Bahnen, insbesondere Leiterbahnen auf extremen Dünnschicht-Substraten oder allgemein auf empfindlichen, beispielsweise temperaturempfindlichen Substraten.

Im Hinblick auf eine möglichst einfach Ausgestaltung ist von besonderer Bedeutung, dass das Verfahren unter atmosphärischen Bedingungen ausgeführt wird. Es ist daher keine Kapselung, kein Vakuum oder dergleichen erforderlich. Auch wird vorzugsweise auf den Einsatz eines Schutzgases verzichtet. Vielmehr kommt das erzeugte Plasma mit der umgebenden Atmosphäre in Kontakt.

Es hat sich gezeigt, dass mit einem derartigen Verfahren die Bahnen auf den unterschiedlichsten Materialien in vergleichbar guter Qualität aufgebracht werden können. Als Substratmaterial eignen sich beispielsweise Kunststoffe, wie PE, ABS, gefüllte oder auch ungefüllte Polymere, sowie Glimmer, Pappe, Papier, Porzellan, Keramiken, wie SIC, Glas. Weiterhin eignen sich auch textile Materialien wie Gewebe, textile Stoffe oder auch Schaumstoffe. Auch ist das Überspritzen von unterschiedlichen aneinander angrenzenden Trägermaterialen problemlos möglich.

Als Pulver werden insbesondere Metallpulver verwendet. Daneben eigenen sich jedoch auch Pulver, bei denen die Partikel aus Kunststoff, Glas oder auch aus Salzen bestehen. Sollen Leiterbahnen erzeugt werden, wird als Pulver vorzugsweise Zinn oder eine Zinnlegierung und alternativ Kupfer oder eine Kupferlegierung herangezogen. Zinn oder eine Zinnlegierung eignet sich für dieses Verfahren insbesondere bei Dünnschichtsubstraten, da aufgrund der geringen Erweichungstemperatur von Zinn ein sehr geringer Energieeintrag erforderlich ist und damit die Zinn-Partikel sehr materialschonend aufgebracht werden können. Neben den nicht-metallischen Substraten können prinzipiell auch metallische Substrate beispielsweise zu Beschichtungszwecken herangezogen werden. Prinzipiell lassen sich beliebige (metallische) Pulver verwenden und es besteht die Möglichkeit, zwei Teilbahnen aus unterschiedlichen Materialen miteinander zu verbinden, beispielsweise ein geeignetes Materialpaar entsprechend der thermoelektrische Spannungsreihe zur Ausbildung von Thermoelementen oder Thermogeneratoren unter Ausnutzung des Thermoeffekts.

Von besonderem Vorteil ist, dass dieses Verfahren zu qualitativ guten Bahnen, insbesondere Leiterbahnen, führt, ohne dass eine Vorbehandlung des Substrats erforderlich und daher auch nicht vorgesehen ist. Auch die hohe Flexibilität durch das maskenfreie Aufbringen macht dieses Verfahren besonders wirtschaftlich. Maßgebend hierfür ist, dass für unterschiedliche Substratmaterialien keine Anpassung der Prozessparameter erforderlich ist. Das bedeutet, dass in Abhängigkeit des speziellen Geräteaufbaus der Spritzvorrichtung unabhängig von der Wahl des Substratmaterials lediglich ein Parametersatz eingestellt zu werden braucht und mit diesem Parametersatz die unterschiedlichsten Substratmaterialien behandelt werden können.

Vorzugsweise umfasst die Spritzlanze einen nach Art einer einfachen Düse ausgebildeten Lanzenkopf, der sich konisch verjüngt und insbesondere spitz zulaufend zur Austrittsöffnung hin ausgebildet ist. Es finden also bewusst keine speziellen Düsen Einsatz, die das Gas auf hohe, insbesondere Überschallgeschwindigkeiten beschleunigen. Die Gasgeschwindigkeit bleibt vielmehr unterhalb der Schallgeschwindigkeit, so dass ein gebündelter, gerichteter Strahl mit geringer kinetischer Energie und geringer Strahlaufweitung austritt. Die Austrittsöffnung hat daher auch einen Durchmesser, der im Bereich der vorgesehenen Bahnbreite liegt.

Da das Pulver zusätzlich innerhalb der Spritzlanze beigefügt wird, ist ein sehr kontrolliertes Verfahren ermöglicht. Insbesondere lässt sich durch die Wahl der Größe der Austrittsöffnung ein begrenzter, ausreichend dünner Spritzstrahl einstellen, so dass zur Erzeugung von Bahnen mit scharfen Begrenzungen keine Masken oder derlei erforderlich und vorgesehen sind. Vielmehr werden vorzugsweise Bahnbreiten im Bereich von unter 1 mm bis zu beispielsweise mehreren 10 mm mit hoher Bahnbreitengenauigkeit eingestellt. Bevorzugt werden Bahnbreiten im Bereich zwischen 0,2mm und 10mm eingestellt, und zwar bevorzugt ausschließlich durch die Wahl der Dimension (Durchmesser) der Austrittsöffnung.

Insbesondere für Bahnbreiten beispielsweise unter 1 mm finden vorzugsweise gezogene Düsen (Lanzenköpfe) aus Glas Einsatz. Durch das Ziehen können - ähnlich wie bei Pipetten etc. - sehr kleine Öffnungen mit hoher Genauigkeit eingestellt werden.

Zur Erzeugung der Bahn ist die Spritzlanze zweckdienlicherweise in einem Spritzabstand im Bereich zwischen 1 mm oder 3 mm bis 35 mm vom Substrat beabstandet. Dieser kurze Spritzabstand in Verbindung mit dem atmosphärischen, kalten Plasma erlaubt die Erzeugung von qualitativ hochwertigen Bahnen aus unterschiedlichsten Materialien auf unterschiedlichsten Trägersubstraten Durch die unmittelbare Nähe des Plasmas zum Trägersubstrat erfährt dieses quasi eine Oberflächenaktivierung, so dass die einzelnen Pulverteilchen gut haften. Aufgrund der vergleichs-weise geringen Plasmatemperatur ist die thermische Belastung sehr gering. Darüber hinaus wirkt sich der geringe Spritzabstand auch positiv auf geringe Bahnbreiten mit einer scharfen und gleichmäßigen Begrenzung aus.

Für die wirtschaftliche Anwendung ist es unabdingbar, dass das Verfahren zuverlässig in einem kontinuierlichen Prozess integriert werden kann. Erst dies ermöglicht es, das Verfahren beispielsweise im Rahmen einer Produktionsstraße an einem Förderband einzusetzen. Mit dem Verfahren bzw. der entsprechenden Vorrichtung zur Durchführung des Verfahrens muss daher ein mehrstündiger und vorzugsweise auch mehrtägiger Betrieb ohne Wartungsarbeiten und Unterbrechungen ermöglicht sein. Aufgrund des direkten Einbringens des Pulvers in die Spritzlanze und der dort ablaufenden Prozesse zur Erzeugung des Plasmas besteht jedoch die Gefahr, dass durch Ablagerungen des zugeführten Pulvers innerhalb der Spritzlanze ein kontinuierlicher Betrieb gefährdet ist.

Weiterhin ist erfindungsgemäß daher unter einem Winkel schräg zur Längsrichtung an der Spritzlanze ein Zuführstutzen für das Pulver vorgesehen. Hierbei sind der Winkel, der Gasstrom, also im Wesentlichen der Strom des ionisierten Gases, sowie der Trägergasstrom, derart aufeinander abgestimmt, dass das Pulver vom Zuführstutzen entlang einer bogenförmigen Bahn zur Austrittsöffnung gelangt, ohne dass es in Kontakt mit Einrichtungen oder Wandungen der Spritzlanze kommt. Durch diese spezielle Einstellung der Prozessparameter, in Abhängigkeit der genannten Bedingungen sowie eventuell weiterer Bedingungen, ist sichergestellt, dass es beispielsweise zu keinen Anbackungen im Bereich der Austrittsöffnung kommt, die diese allmählich zusetzen würden. Auch ist durch diese Maßnahmen verhindert, dass sich einzelne Partikel beispielsweise an den Innenwänden der Spritzlanze oder auch an einer Kathode zur Erzeugung des Lichtbogens ablagern. Der Winkel liegt hierbei zwischen 20° bis 70°, insbesondere im Bereich zwischen 20° und 30°. Unter diesem Winkel ergibt sich eine besonders geringe Ablenkung bei gleichzeitig kompakter Ausgestaltung, so dass das Pulver auf einem annähernd direkten Weg zur Austrittsöffnung gelangt.

Um einen kontinuierlichen und störungsfreien Betrieb zuverlässig zu erhalten ist die Austrittsöffnung von den Zuführstutzen lediglich etwa 1 cm beabstandet. Bezugspunkt ist hierbei eine Mittenlinie des Zuführstutzens. Gleichzeitig ist der Zuführstutzen zu der Kathode im Bereich von etwa 5 - 7 cm beabstandet. Dieser Abstand wird hierbei in Abhängigkeit des verwendeten Materials für das Pulver eingestellt. Je niedrig schmelzender das Material ist, desto kleiner ist der Abstand zu der Kathode. Bei der Verwendung von Zinn liegt dieser Abstand daher im unteren Bereich, wohingegen bei der Verwendung des im Vergleich zum Zinn höher schmelzenden Kupfers der Abstand im oberen Bereich liegt.

Vorzugsweise sind mehrere Zuführstutzen um den Umfang der Spritzlanze verteilt angeordnet. Dies dient u.a. zur Erzeugung eines möglichst achsparallelen Strahls. Insbesondere sind gleichmäßig um den Umfang verteilt 3 bis 6 Zuführstutzen angeordnet.

Weiterhin ist für einen kontinuierlichen Betrieb vorgesehen, dass das ionisierbare Gas sowie das Trägergas etwa unter dem gleichen Druck in die Spritzlanze einströmen. Es herrschen daher möglichst gleichmäßige Bedingungen innerhalb der Spritzlanze und es treten keine übermäßigen Turbulenzen auf. Derartige Turbulenzen würden in nachteiliger Weise dazu führen, dass das zugeführte Pulver nicht zielgerichtet zu der Austrittsöffnung gelangen könnte. Der Druck liegt hierbei im Bereich zwischen 1 und 10 bar (1*10⁵ - 10*10⁵ Pa). Insbesondere liegt er im Bereich von 2*10⁵ Pa.

Weiterhin ist vorgesehen, dass sowohl das ionisierbare Gas als auch das Trägergas aus einer gleichen Gasquelle stammen. Ein Gesamt-Gasvolumenstrom wird daher aufgeteilt in einen Volumenstrom für das ionisierbare Gas und in einen für das Trägergas. Hierdurch weisen die beiden Volumenströme etwa das gleiche Druckniveau auf. Für die beiden Gasströme ist daher keine aufwändige Druckregelung erforderlich. Zweckdienlicherweise liegt hierbei der Anteil des Trägergases am Gesamt-Gasvolumenstrom bei etwa 5 - 15% und insbesondere bei etwa 8%. Der Volumenstrom des Trägergases liegt vorzugsweise zwischen 10 und 25 l/min und insbesondere im Bereich zwischen 15 - 19 l/min. Die Geschwindigkeit der Gasströme liegt vorzugsweise unter 200m/s, so dass die Anlage geräuscharm arbeitet und keine Schallschutzmaßnahmen erforderlich sind.

Bevor das Trägergas mit dem Pulver der Spritzlanze zugeführt wird, wird das Trägergas durch eine Dosiervorrichtung geleitet, um das Pulver aufzunehmen. Diese Dosiervorrichtung umfasst hierbei in einer zweckdienlichen Ausgestaltung einen Pulvervorratsbehälter sowie eine Dosierkammer, in die das Pulver aus dem Pulvervorratsbehälter unter Ausnutzung der Gravitationskraft über ein Dosierrohr auf einen vorzugsweise rotierenden Dosierteller dosiert wird. Vom Dosierteller wird das Pulver mittels einer Sauglanze aufgenommen. Um dies zu erreichen wird das Trägergas über einen Einlass in die Dosierkammer eingeleitet, so dass innerhalb der Dosierkammer etwa der Druck des Trägergrasstroms herrscht. Das Trägergas verlässt die Dosierkammer wieder über die Sauglanze. Beim Einströmen in die Öffnung der Sauglanze wird das in unmittelbarer Nähe dieser Öffnung befindliche Pulver mitgerissen und dann durch den Trägergasstrom mitgetragen.

Um eine möglichst gleichmäßige und kontinuierliche Zuleitung von Pulver auf den Dosierteller zu gewährleisten, wird der Pulvervorratsbehälter zweckdienlicherweise mit Druck, insbesondere mit dem Druck des Trägergases, beaufschlagt. Hierdurch wird durch eine konstruktiv einfache Art und Weise das Pulver in Richtung auf das Dosierrohr gedrückt, so dass sich vor dem Dosierrohr keine Hohlräume ausbilden. Ergänzend oder alternativ hierzu wird das Pulver zumindest im Bereich seines Eintritts in das Dosierrohr Vibrationen ausgesetzt. Hierzu ist der Pulvervorratsbehälter mit einem geeigneten Vibrator ausgebildet. Beispielsweise vibriert der Behälter in seinem unteren Bereich oder ein Vibrationselement dringt direkt in den Pulvervorrat ein.

Vorzugsweise weist der Dosierteller eine umlaufende Nut auf, in die das Dosierrohr und die Sauglanze bevorzugt an etwa gegenüberliegenden Positionen eintauchen. Die Breite der Nut ist hierbei lediglich geringfügig, beispielsweise um ein geringes Toleranz- oder Spaltmaß von wenigen Zehntel-Millimeter, größer als der Außendurchmesser insbesondere der Sauglanze. Insgesamt wird hierdurch im Bereich der Öffnung der Sauglanze, die in der Nut liegt, eine hohe Einströmgeschwindigkeit erreicht, so dass das Pulver zuverlässig mitgerissen wird.

Die Dosierung wird hierbei zweckdienlicherweise derart eingestellt, dass eine Pulverauftragsrate im Bereich von 1 - 20 g/min und insbesondere von etwa 5 g/min eingestellt wird. Bei einer Pulverauftragsrate von 5 g/min bei der Verwendung insbesondere von Zinn wird hierbei der Volumenstrom des Trägergases auf etwa 17 l/min eingestellt.

Für einen kontinuierlichen, unterbrechungsfreien Betrieb beispielsweise in einer Produktionsanlage, die 24 Stunden am Tag in Betrieb ist (3-Schicht-Betrieb), wird das Pulver dem Vorratsbehälter vollautomatisch über eine Zuführleitung zugeführt. Das Pulver wird hierzu über die Zuführleitung in den Behälter eingeblasen. Der Vorratsbehälter ist daher kein abgeschlossener Behälter, der manuell ausgetauscht oder manuell aufgefüllt werden muss.

Gemäß einer zweckdienlichen Weiterbildung sind mehrere mit unterschiedlichen Pulvern gefüllte Vorratsbehälter vorgesehen. Die unterschiedlichen Pulver, also insbesondere unterschiedliche Pulvermaterialien, werden in einem definierten Mischungsverhältnis der Spritzlanze zugeführt. Durch diese Maßnahme können problemlos Leiterbahnen in einer gewünschten Materialzusammensetzung mit genau definiertem Eigenschaftsprofil erzeugt werden.

Weiterhin ist vorgesehen, dass die Spritzlanze mit einer Relativgeschwindigkeit im Bereich von 10 cm/min - 90 cm/min bezüglich des Substrats verfahren wird. Prinzipiell ist es hierbei auch möglich, dass das Substrat verfahren und die Spritzlanze ortsfest gehalten wird.

Unterbrechungen der Leiterbahn können allein durch eine Erhöhung der Relativgeschwindigkeit erreicht werden. Hierdurch besteht die vorteilhafte Möglichkeit, unterschiedliche elektrische Leiterbahnen, die nicht in elektrischem Kontakt miteinander stehen, in einem kontinuierlichen Spritzverfahren zu erzeugen, ohne dass der Spritzbetrieb eingestellt werden müsste. Um die Unterbrechung auszubilden, wird die Relativgeschwindigkeit kurzfristig auf einen Wert insbesondere größer 100 cm pro Minute erhöht.

Zweckdienlicherweise dient die aufgebrachte leitfähige Bahn als Heizleiterbahn, die insbesondere mäanderförmig aufgebracht wird. Bevorzugt ist diese Heizleiterbahn zur Beheizung eines Spiegels, insbesondere eines Kraftfahrzeug-Spiegels vorgesehen.

Daneben sind prinzipiell eine Vielzahl von weiteren Anwendungsmöglichkeiten gegeben, um die elektrisch leitfähige Bahn für Heizzwecke oder zur Beheizung von speziellen Bauteilen heranzuziehen.

Generell wird die Leiterbahn für elektrische Bauteile herangezogen, bei denen die elektrische Leitfähigkeit ausgenutzt wird. Insbesondere dient hierbei die Leiterbahn mit ihrem direkten Aufbringen auf ein Bauteil, beispielsweise auf ein Kraftfahrzeug-Bauteil, zur Stromführung im Rahmen eines Bordnetzes. Die Leiterbahn kann aufgrund ihrer Leitfähigkeit aber auch als Abschirmung, als elektrischer Kontakt, als Antenne etc. ausgebildet sein. Die Ausbildung der Antenne ist hierbei insbesondere im Rahmen einer so genannten RFID-Anwendung (Radio Frequency Identification) vorgesehen sein. Durch die Ausbildung unterschiedlich breiter Leiterbahnteilstücke können auch Sicherungselemente etc. ausgebildet werden.

Daneben besteht mit diesem Verfahren prinzipiell auch die Möglichkeit, Beschichtungen etc. vorzunehmen.

Zweckdienlicherweise wird dieses Verfahren eingesetzt, um die erzeugte Bahn durchgehend auf einander angrenzende Substrate unterschiedlicher Materialien aufzubringen. Hierbei wird in vorteilhafter Weise ausgenutzt, dass die Haftung nahezu materialunabhängig ist. Materialübergänge können daher problemlos überspritzt werden. Dies ist insbesondere bei Hybridbauteilen von besonderem Vorteil, bei denen unterschiedliche Materialien miteinander verbunden sind.

Das Verfahren eignet sich insbesondere auch zur Durchkontaktierung von Leiterplatten, beispielsweise in der Leistungselektronik. Hierzu wird ein Durchtrittsloch in der Leiterplatte für eine Leistungselektronik mit der elektrisch leitfähigen Beschichtung versehen. Hierbei kann vorgesehen sein, dass die Relativgeschwindigkeit gleich null ist.

Die Aufgabe wird gemäß der Erfindung weiterhin gelöst durch eine Vorrichtung zum Aufspritzen einer Bahn, insbesondere Leiterbahn, mit den Merkmalen des Anspruchs 13.

Zweckdienlicherweise ist die Spritzlanze zweiteilig ausgebildet und umfasst ein Plasmarohr, an das ein Lanzenkopf austauschbar befestigt ist. Der Lanzenkopf weist den Zuführstutzen sowie die Austrittsöffnung auf. Durch die Austauschbarkeit können durch unterschiedlich ausgebildete Lanzenköpfe unterschiedliche Bahnen erzeugt werden, die sich beispielsweise im Hinblick auf Ihre Bahnbreite unterscheiden. Auch besteht die Möglichkeit, durch unterschiedlich ausgebildete Lanzenköpfe, bei denen beispielsweise die Lage und Orientierung des Zuführstutzens unterschiedlich ist, die Lanzenköpfe an unterschiedliche Pulverarten anzupassen. Zweckdienlicherweise sind hierbei die unterschiedlich ausgebildeten Lanzenköpfe automatisch und in einfacher Weise austauschbar, indem sie in einer Wechseleinheit, beispielsweise einem Revolverkopf, aufbewahrt sind.

Die im Hinblick auf das Verfahren angeführten Vorteile und bevorzugten Ausgestaltungen sind sinngemäß auch auf die Vorrichtung, übertragbar.

Ausführungsbeispiele der Erfindung werden im Folgenden anhand der Zeichnung näher erläutert. Es zeigen hierin jeweils in schematischen und teilweise stark vereinfachten Darstellungen:
- Fig. 1: eine Querschnittsdarstellung durch eine Spritzlanze zur Erläuterung des Spritzverfahrens,
- Fig. 2: eine Querschnittdarstellung einer Dosiervorrichtung,
- Fig. 3: eine Aufsicht auf einen Dosierteller,
- Fig. 4: eine schematische Darstellung zur Erläuterung des Gesamtprozesses sowie
- Fig. 5A,5B: eine Schnittansicht bzw. Aufsicht auf einen beheizbaren Spiegel.

In den Figuren sind gleich wirkende Teile mit den gleichen Bezugszeichen versehen.

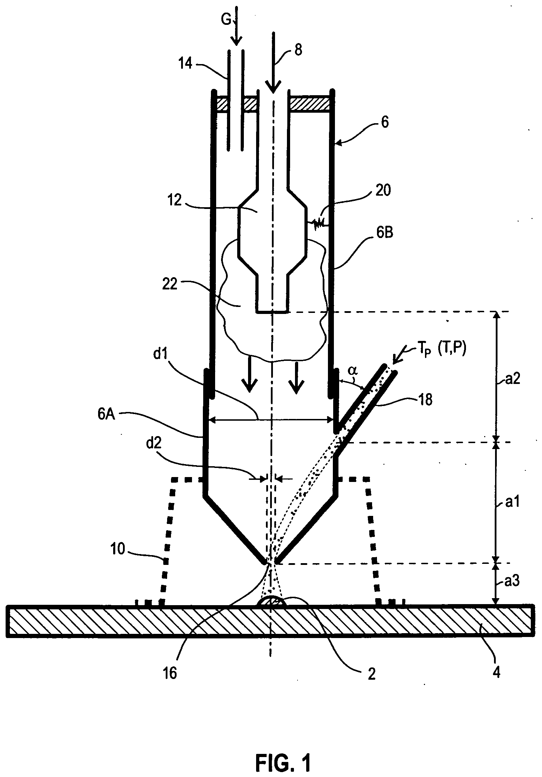

Zum Aufbringen einer Bahn, insbesondere einer Leiterbahn 2 auf ein Substrat 4, insbesondere aus einem Isolationsmaterial, wird die in Fig. 1 dargestellte Spritzlanze 6 verwendet. Zum Erzeugen der Leiterbahn 2 wird die Spritzlanze 6 relativ zum Substrat verfahren. Hierbei wird die Spritzlanze 6 insbesondere an einer Verstelleinrichtung befestigt, die eine Verstellmöglichkeit entlang von drei Achsen aufweist, also innerhalb der durch das Substrat 4 definierten X-Y-Ebene als auch innerhalb einer Z-Richtung, die durch die Längsrichtung 8 der Spritzlanze definiert ist. Die Verstelleinrichtung ist hierbei beispielsweise eine mehrachsige, mit Linearantrieben ausgebildete Einrichtung. Alternativ hierzu ist die Verstelleinrichtung ein mehrachsiger, insbesondere sechsachsiger Industrieroboter. In diesem Fall ist die Spritzlanze 6 an einer Roboterhand des Industrieroboters befestigt.

Die Spritzlanze 6 wird über dem Substrat 4 verfahren, um ein durch die Bewegung der Spritzlanze 6 definiertes Leiterbahnmuster zu erzeugen. Es wird hierbei keinerlei Maskierungshilfe verwendet. Das Leiterbahnmuster wird allein durch die Relativbewegung des Substrats 4 bezüglich der Spritzlanze 6 definiert. Auch ist keinerlei Vorbehandlung des Substrats 4 vorgesehen. Vielmehr wird die Leiterbahn 2 unmittelbar auf die Oberfläche des Substrats 4 aufgebracht.

An der Spritzlanze 6 kann bei Bedarf eine Saugglocke 10 befestigt sein, die in Fig. 1 punktiert dargestellt ist. An dieser Saugglocke ist ein hier nicht näher dargestellter Sauganschluss angeordnet, mit dessen Hilfe ein Unterdruck in der Saugglocke 10 eingestellt wird. Hierdurch besteht die Möglichkeit, überschüssiges Material abzusaugen und gegebenenfalls einer Wiederverwertung zuzuführen. Die Verwendung einer derartigen Saugglocke ist beispielsweise bei einem aus der WO 02/058887 A1 zu entnehmenden Beschichtungsverfahren bekannt. Vorzugsweise erfolgt das Aufbringen der Leiterbahn 2 ohne Saugglocke 10. Dies bringt insbesondere bei dreidimensional konturierten Substraten 4 Vorteile, da eine Abdichtung zur Erzeugung des Unterdrucks in der Saugglocke 4 in diesen Fällen nicht oder nur sehr schwer möglich ist. Vielmehr kann ohne Saugglocke 10 die Spritzlanze 6 frei und beliebig auch über komplexe Oberflächenstrukturen des Substrats 4 geführt werden.

Die Spritzlanze 6 selbst ist ein in etwa rohrförmiges Gebilde, das sich in Längsrichtung 8 erstreckt. Die Spritzlanze 6 ist in zwei Modulteile unterteilt, nämlich einen unteren Lanzenkopf 6A und ein oberes Plasmarohr 6B. Diese beiden Bauteile sind miteinander lösbar befestigt. Innerhalb des Plasmarohrs 6B wird das Plasma im Betrieb erzeugt. Im Lanzenkopf 6A erfolgt die Zuführung des Pulvers in die Spritzlanze 6. Insbesondere ist der Lanzenkopf 6A angeschraubt oder auch durch eine Schnellverbindungsart, wie beispielsweise eine Bajonettverbindung, an dem Plasmarohr 6B befestigt. Durch diese lösbare Befestigung lässt sich der Lanzenkopf 6A problemlos austauschen und durch einen anderen ersetzten. Insbesondere lässt sich durch diese Maßnahme ein einfacher "Werkzeugwechsel" durchführen, um beispielsweise Leiterbahnen 2 mit unterschiedlichen Leiterbahnbreiten zu erzeugen.

Im bzw. am Plasmarohr 6B ist eine Kathode 12 sowie eine Zuführung 14 für ein ionisierbares Gas, insbesondere Stickstoff N vorgesehen. An seiner Oberseite ist die Spritzlanze 6 durch einen isolierenden Deckel verschlossen. Gegenüberliegend am andern stirnseitigen Ende weist die Spritzlanze 6 eine Austrittsöffnung 16 auf. Im unteren Bereich unterhalb der Kathode 12 und als Teil des Lanzenkopfes 6A ist seitlich ein Zuführstutzen 18 angeordnet. Die Spritzlanze 6 zumindest im unteren Bereich unterhalb der Kathode weist einen Innendurchmesser d1 im Bereich von etwa 1 cm und beispielsweise von 8 mm auf. Der Durchmesser d2 der Austrittsöffnung 16 liegt bei diesem Ausführungsbeispiel im Bereich von wenigen Millimetern, beispielsweise von 3 mm. Der Innendurchmesser d1 beträgt allgemein etwa das zwei- bis fünffache des Durchmessers d2 der Austrittsöffnung 16. Prinzipiell lässt sich die Austrittsöffnung über einen weiten Bereich beispielsweise von 0,2 mm bis zu 10 mm oder auch darüber variieren. Bei den größeren Durchmessern wird der ein entsprechend größerer Innendurchmesser d1 gewählt.

Der Zuführstutzen 18 ist von der Austrittsöffnung 16 um einen Abstand a1 zu der Austrittsöffnung 16 beabstandet. Gleichzeitig ist der Zuführstutzen 18 zu der Kathode 12 um einen Abstand a2 beabstandet. Der Abstand wird hierbei jeweils gemessen ausgehend von der Mitte der Eintrittsöffnung des Zuführstutzens 18. Der Abstand a1 beträgt etwa 1 cm, insbesondere bei der Verwendung von Zinn als Spritzmaterial. Der Abstand a2 liegt demgegenüber in einem Bereich von 5 - 7 cm, bei Zinn wird ein Abstand von etwa 5 cm eingestellt. Der unterschiedliche Abstand a1, a2 wird durch die Wahl von unterschiedlich ausgebildeten Lanzenköpfen 6A eingestellt. In Abhängigkeit von unterschiedlichen Spritzmaterialien werden daher vorzugsweise unterschiedliche Lanzenköpfe 6A herangezogen.

Die Austrittsöffnung 16 ist wiederum um einen Spritzabstand a3 von der Oberfläche des Substrats 4 beabstandet. Dieser Abstand liegt im Bereich zwischen 1 und 35 mm. Durch diesen vergleichsweise sehr kurzen Spritzabstand a3 lassen sich diskrete, scharf begrenzte Leiterbahnen 2 problemlos erzeugen.

Im Betrieb wird an die Kathode 12 eine Spannung, insbesondere eine Wechselspannung, angelegt. Im Ausführungsbeispiel wird hierbei eine Wechselspannung mit einer Frequenz von mehreren kHz, insbesondere von 14 kHz angelegt. Durch diese hohe Spannung entsteht ein nicht ortsfester Lichtbogen 20 zwischen der Kathode und der als Anode wirkenden zylinderförmigen Wandung der Spritzlanze 6. Die elektrische Leistung, mit der die Spritzlanze 6 betrieben wird, liegt im Ausführungsbeispiel vorzugsweise im Bereich von einigen 100 Watt, beispielsweise im Bereich zwischen 300 und 500 W.

Gleichzeitig wird von oben über die Zuführung 14 das ionisierbare Gas G, im Ausführungsbeispiel Stickstoff, unter einem Druck im Bereich von einigen bar, vorzugsweise von 2 bar zugeführt. Das Gas G wird aufgrund des Lichtbogens 20 ionisiert und bildet ein Plasma 22. Dieses ist in der Fig. 1 schematisch durch eine Plasma-Wolke dargestellt. Dieses Plasma 22 breitet sich in Richtung zur Austrittsöffnung 16 aus, wie durch die Pfeile dargestellt ist. Aufgrund der nur geringen elektrischen Leistung, die eingebracht wird, handelt es sich hierbei um ein kaltes Plasma mit Temperaturen deutlich unter 3000 K.

Weiterhin wird über den Zuführstutzen 18 ein Partikelstrom T_{P} in den Innenraum der Spritzlanze 6 im Bereich des Lanzenkopfs 6A eingebracht. Der Partikelstrom T_{P} ist gebildet durch einen Volumenstrom eines Trägergases T, im Ausführungsbeispiel ebenfalls Stickstoff, sowie von einzelnen Partikeln eines Pulvers P, das als Spritzmaterial herangezogen wird. Im Ausführungsbeispiel wird als Pulver P ein Zinnpulver verwendet mit einer Teilchengröße im Bereich von beispielsweise 1 µm bis 100 µm Partikeldurchmesser, Der Volumenstrom des Trägergases T ist beispielsweise auf 17 Liter pro Minute eingestellt. Gleichzeitig ist der Partikelstrom des Pulvers P auf 5 Gramm pro Minute eingestellt. Das Trägergas T wird ebenfalls unter einem Druck von wenigen Bar, d.h. unter dem gleichen Druck wie das Gas G, also im Ausführungsbeispiel von 2 bar, zugeführt. Der Partikelstrom T_{P} tritt hierbei zu der Mittenrotationsachse der Spritzlanze 6 und damit zu der Längsrichtung 8 unter einem Winkel α in die Spritzlanze 8 ein. Der Winkel α entspricht hierbei dem Winkel, unter dem der Zuführstutzen 18 gegenüber der Längsrichtung 8 geneigt ist. Der Winkel α liegt in einem Bereich zwischen 20 und 30°.

Durch die im Ausführungsbeispiel gewählten Prozessparameter wird in Verbindung mit dem Winkel α erreicht, dass der Partikelstrom T_{P} bogenförmig zu der Austrittsöffnung 16 gelangt, ohne dass einzelne Partikel des Pulvers P mit der Kathode 12 oder einem Wandungsbereich an der Austrittsöffnung 16 in Kontakt kommen. Es bilden sich daher keine den kontinuierlichen Betrieb störende Ablagerungen etc. Insgesamt haben sich die hier beschriebenen Prozessparameter als besonders vorteilhaft bei der Verwendung von Zinn als Pulver P herausgestellt. Insbesondere die dynamischen Prozessparameter, die Volumenströme des Gases G, des Trägergases T sowie der Massenstrom des Pulvers P haben sich als besonders vorteilhaft erwiesen, um einen stabilen dauerhaften Betrieb zu erreichen. Die Zuführung des Partikelstroms T_{P} ist besonders kritisch, um einen dauerhaften Betrieb sicherzustellen.

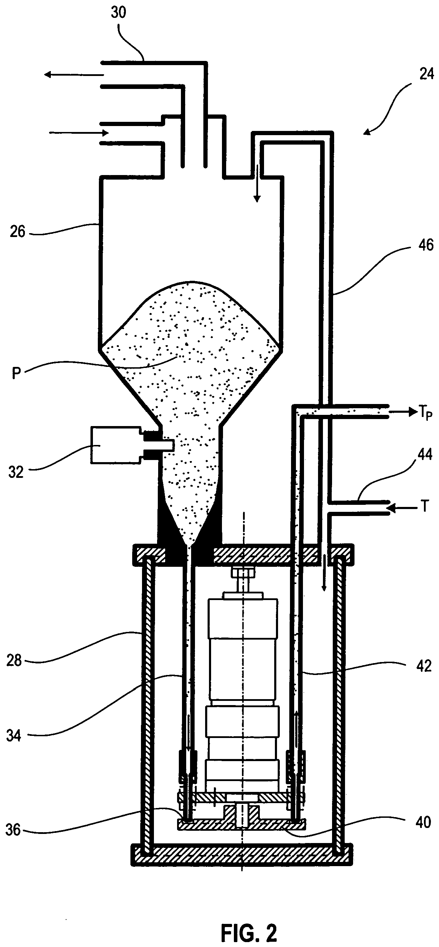

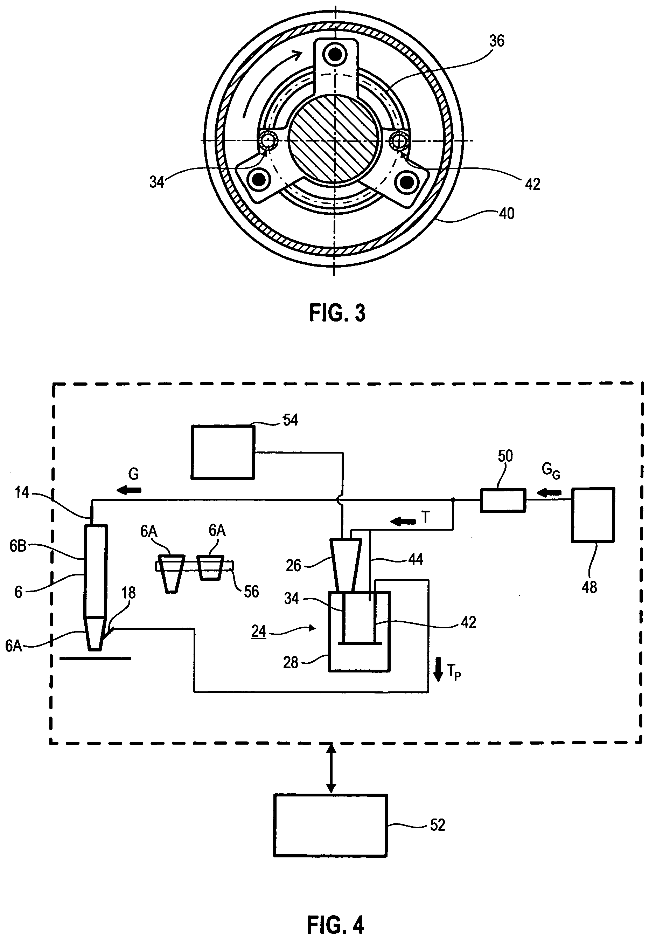

Von entscheidender Bedeutung für den erforderlichen kontinuierlichen Betrieb ist daher insbesondere auch die Zudosierung des Partikelstroms T_{P}. Dessen Bereitstellung wird nunmehr im Zusammenhang mit den Fig. 2 und 3 näher ausgeführt. Fig. 2 zeigt hierbei eine schematische Querschnittsdarstellung einer Dosiervorrichtung 24. Diese umfasst einen Pulvervorratsbehälter 26, der auf eine Dosierkammer 28 aufgesetzt ist. In dem Pulvervorratsbehälter 26 wird das Pulver P bevorratet. Über Versorgungsleitungen 30 lässt sich in Verbindung mit einem Füllstandssensor 32 automatisch eine zu jeder Zeit ausreichende Menge an Pulver P bereitstellen. Am unteren Ende der Dosierkammer 28 ist diese trichterförmig ausgebildet und mündet in ein Dosierrohr 34, welches in die Dosierkammer 28 eindringt. Das Dosierrohr 34 endet mit seiner Mündungsöffnung in einer Ringnut 36 eines über einen Elektromotor 38 rotierbaren Dosiertellers 40. Die Drehgeschwindigkeit des Dosiertellers 40 ist in Abhängigkeit der gewünschten Auftragsrate variierbar und beträgt beispielsweise 5 bis 45 Umdrehungen pro Minute, bei einem Durchmesser der Ringnut 36 von etwa 25 mm. Gegenüberliegend zum Dosierrohr 34 taucht in die Ringnut 36 eine Sauglanze 42 mit ihrer Eintrittsöffnung ein. Die Sauglanze 42 sowie das Dosierrohr 34 weisen den gleichen Innendurchmesser von wenigen mm, beispielsweise von etwa 2 mm auf. Korrespondierend hierzu weist die Ringnut 36 eine Breite auf, die etwas oberhalb des Außendurchmessers der Sauglanze 42 bzw. des Dosierrohrs 34 liegt. Im Ausführungsbeispiel weist die Ringnut 36 daher eine Breite von etwa 2 mm auf. Gleichzeitig weist die Ringnut 36 eine Tiefe von wenigen Millimetern, beispielsweise von etwa 1 mm auf.

Beim Betrieb wird über eine Zuleitung 44 das Trägergas in die Dosierkammer 28 geleitet. Über eine Zweigleitung 46 wird zugleich auch der Pulvervorratsbehälter 26 mit dem Druck des Trägergases T beaufschlagt. Die Versorgungsleitungen 30 sind üblicherweise über hier nicht näher dargestellte Ventile gesperrt, so dass das Trägergas T nicht über diese Leitungen entweicht. Durch diese Maßnahme ist der Pulvervorratsbehälter 26 unter Druck gesetzt, so dass das Pulver P in Richtung zu dem Trichter gedrückt wird. Zusätzlich ist ein Vibrationselement (nicht dargestellt) vorgesehen, welches dafür sorgt, dass das Pulver P gleichmäßig über das Dosierrohr 34 nachgeführt wird. Das Pulver P gelangt über das Dosierrohr 34 in die Ringnut 36. Durch die Rotation des Dosiertellers 40 wird die Ringnut 36 kontinuierlich über das Dosierrohr 34 mit Pulver zumindest teilweise angefüllt.

Über die Sauglanze 42 verlässt das Trägergas T die Dosierkammer 28 wieder. Hierzu strömt das Trägergas T über die in der Ringnut 36 angeordnete Öffnung der Sauglanze 42 in diese ein. Hierbei wird das sich in der Ringnut 36 befindliche Pulver P mitgerissen und vollständig mit eingesaugt, so dass über die Sauglanze 42 der Partikelstrom T_{P} aus der Dosiereinrichtung 24 entweicht und zu dem Zuführstutzen 18 der Spritzlanze 6 zugeführt wird.

Das Gesamtverfahren wird nochmals anhand der Fig. 4 beschrieben.

Aus einer zentralen Gasversorgung 48 (Inertgas, insbesondere Stickstoff) wird ein Gesamt-Gasstrom G_{G} bereitgestellt. Dieser wird über ein hochgenaues Druck-Steuergerät 50 geführt und auf den gewünschten Betriebsdruck von im Ausführungsbeispiel 2 bar gedrosselt. Im Anschluss an das Drucksteuergerät 50 wird der Gesamt-Gasstrom G_{G} in den Gasstrom G und den Trägergasstrom T aufgeteilt. Der Gasstrom G wird der Zuführung 14 der Spritzlanze 6 zugeleitet. Der Trägergasstrom T wird der Dosiereinrichtung 24 zugeführt und dort wiederum aufgeteilt, wie zu Fig. 2 beschrieben. In der Dosiereinrichtung 34 vermischt sich das Trägergas T mit dem Pulver P und wird als Partikelstrom T_{P} dem Zuführstutzen 18 zugeführt. Abgesehen von dem durch die zentrale Gasversorgung 48 bereitgestellten Druck sind keine weiteren Fördereinrichtungen vorgesehen. Der gesamte Prozess wird insbesondere automatisch gesteuert und geregelt mit Hilfe einer Steuereinrichtung 52. Diese steuert und regelt daher die einzelnen Komponenten wie Spritzlanze 6, Dosiereinrichtung 24, Drucksteuergerät 50 sowie eine Pulverversorgungseinheit 54, für die gegebenenfalls eine Pulverfördereinrichtung vorgesehen sein kann. Insbesondere steuert die Steuereinheit 52 auch die Energieversorgung der Spritzlanze 6 und übernimmt beispielsweise auch die Ansteuerung eines Industrieroboters, mit dessen Hilfe die Spritzlanze 6 verfahren wird. Die Steuereinheit 52 kann hierbei auf mehrere Einzelkomponenten aufgeteilt sein.

In der Fig. 4 ist weiterhin beispielhaft eine Wechseleinheit 56 dargestellt, die Parkpositionen für mehrere unterschiedliche Lanzenköpfe 6A bereitstellt. die Wechseleinheit ist beispielsweise ein insbesondere unmittelbar an der Verstelleinrichtung (Roboterhand) angeordnetes (Dreh-) Magazin (Revolverkopf). Hiermit ist ein schneller und automatischer Wechsel des Lanzenkopfes 6A ermöglicht. Somit ist es mit nur einer Verstelleinrichtung möglich, unterschiedlichste Leiterbahnen 2 zu erzeugen.

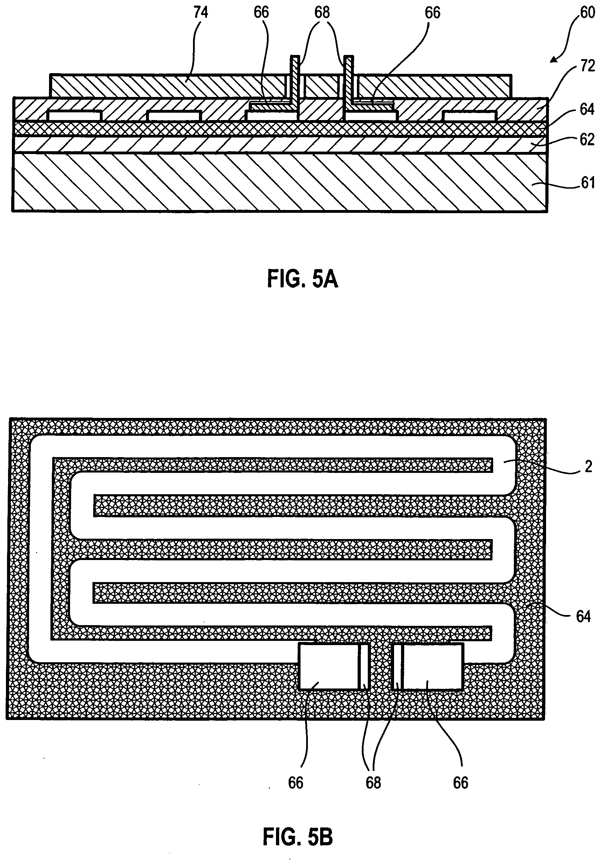

Anhand der Fig. 5A,5B wird nunmehr ein Anwendungsfall für das Aufbringen einer Leiterbahn 2 auf ein elektrisches Bauteil am Beispiel eines beheizbaren Spiegels 60 dargestellt. Der Spiegel 60 umfasst, wie aus Fig. 5A zu entnehmen ist, eine Glasschicht 61, auf die eine aus Chrom bestehende Reflexionsschicht 62 aufgebracht ist. An diese schließt sich wiederum eine Grundschicht 64, insbesondere bestehend aus einem Decklack an. Auf dieser ist die Leiterbahn 2 mäanderförmig ausgebildet. Ihre Enden sind mit elektrischen Kontakten 66 versehen. Diese dienen zum Anschluss von Leitungen 68, beispielsweise über Stecker 70. Über die mäanderförmige Leiterbahn 2 ist eine Splitterschutzschicht 72 angebracht, auf der wiederum eine Trägerplatte 74 angeordnet ist. Die Reflexionsschicht 62 weist eine Dicke von wenigen µm auf. Auch die Grundschicht 64 weist eine Dicke im µm-Bereich auf und ist geringer als 1 mm.

Mit dem hier beschriebenen Verfahren lässt sich die Leiterbahn 2 als Heizbahn aufbringen, ohne dass die Grundschicht 64 übermäßig beansprucht und insbesondere beschädigt wird. Durch diese Maßnahme ist daher ein effizientes, schnelles und zugleich betriebssicheres Aufbringen der als Heizbahn ausgeführten Leiterbahn 2 ermöglicht.

Neben diesem hier beschriebenen speziellen Anwendungsgebiet für einen elektrisch beheizbaren Spiegel 60 lassen sich mit dem hier beschriebenen Verfahren auch die unterschiedlichsten elektrischen Bauteile mit einer Leiterbahn 2 versehen. Beispielsweise lassen sich hierdurch ganze Kabelsätze unmittelbar auf einem Bauteil durch Aufspritzen generieren. Grundsätzlich lässt sich die Leiterbahn 2 als Heizleiter auf den unterschiedlichsten Substraten und für unterschiedlichste Anwendungen aufbringen. Mit der Leiterbahn 2 lassen sich auch elektrische Funktionselemente, wie beispielsweise Antennen, Widerstände, Abschirmungen etc. ausbilden, indem die Eigenschaften der Leiterbahn 2 geeignet eingestellt werden. Schließlich bietet sich dieses Verfahren auch zur Ausbildung von Kontakten und Kontaktelementen an. Beispielsweise zur Durchkontaktierung von Leiterplatten insbesondere in der Leistungselektronik oder auch zur Kontaktierung von Piezo-Elementen.

Insgesamt zeichnet sich das hier beschriebene Verfahren durch seine sehr hohe Flexibilität, seinen universellen Einsatz auf unterschiedlichsten Materialien, seine Dauerbetriebsfähigkeit sowie die schonende Behandlung des Substrats 4 aufgrund der nur geringen eingebrachten Energie aus. Im Hinblick auf die Dauerbetriebsfähigkeit auch in einem 24h-Dreischicht-Betrieb sind folgende Maßnahmen hervorzuheben, die vorzugsweise in Kombination eingesetzt werden: Eine kontinuierliche Pulverzuführung in den oder die Vorratsbehälter (26), eine automatische Einstellung der Bahnbreite über die Austrittsöffnung des Lanzenkopfes (6A), insbesondere in Verbindung mit der automatischen, robotergesteuerten Austauschbarkeit des Lanzenkopfes und der Bereitstellung von mehreren unterschiedlichen Lanzenköpfen (6A) in einer Wechseleinheit (56). Die Lanzenköpfe (6A) sind hierzu mit einem Schnellwechselanschluss ausgebildet, der automatisiert betätigbar ist. Auch für die Befestigung von Zuleitungen an den Zuführstutzen (18) sind vorzugsweise automatisiert betätigbare Schnellwechselanschlüsse vorgesehen.

Für die Integration in eine Produktionsanlage ist weiterhin von Vorteil, dass die Gasgeschwindigkeiten innerhalb des Systems vergleichsweise gering sind und unter 200m/s liegen. so dass die Geräuschbelastung gering ist. Überschüssiges Pulver kann vom Substrat mit Hilfe von handelsüblichen Saugern abgesaugt werden.

Ein weiterer besonderer Vorteil ist darin zu sehen, dass der Betrieb sehr robust ist und die einmal eingestellten Spritzparameter wie Gasgeschwindigkeiten, Pulver-Zuführrate etc. unabhängig beispielsweise von den Substraten beibehalten werden können.

### Bezugszeichenliste

- 2: Leiterbahn
- 4: Substrat
- 6: Spritzlanze
- 6A: Lanzenkopf
- 6B: Plasmarohr
- 8: Längsrichtung
- 10: Saugglocke
- 12: Kathode
- 14: Zuführung
- 16: Austrittsöffnung
- 18: Zuführstutzen
- 20: Lichtbogen
- 22: Plasma
- 24: Dosiereinrichtung
- 26: Pulvervorratsbehälter
- 28: Dosierkammer
- 30: Versorgungsleitung
- 32: Füllstandssensor
- 34: Dosierrohr
- 36: Ringnut
- 38: Elektromotor
- 40: Dosierteller
- 42: Sauglanze
- 44: Zuleitung
- 46: Zweigleitung
- 48: zentrale Gasversorgung
- 50: Drucksteuergerät
- 52: Steuereinheit
- 54: Pulverversorgungseinheit
- 56: Wechseleinheit
- 60: beheizbarer Spiegel
- 61: Glasschicht
- 62: Reflexionsschicht
- 64: Grundschicht
- 66: Kontakt
- 68: Leitung
- 70: Stecker
- 72: Splitterschutz
- 74: Trägerplatte

- a1: Abstand 18 - 16
- a2: Abstand 18 - 20
- a3: Spritzabstand
- d1: Innendurchmesser Spritzlanze
- d2: Durchmesser Austrittsöffnung
- α: Winkel
- G: ionisierbares Gas
- P: Pulver
- T: Trägergas
- T_{P}: Partikelstrom
- T_{G}: Gesamt-Gasstrom

## Patentansprüche

1. Verfahren zum Aufspritzen einer Bahn, insbesondere einer Leiterbahn (2), auf ein Substrat (4) mit Hilfe einer sich in einer Längsrichtung (8) erstreckenden Spritzlanze (6), die mit einer Relativgeschwindigkeit relativ zu dem Substrat (4) bewegt wird, wobei der Spritzlanze (6) unter atmosphärischen Bedingungen ein ionisierbares Gas (G) zugeführt wird, das durch einen in der Spritzlanze (6) erzeugten Lichtbogen (20) ionisiert wird, so dass ein kaltes Plasma (22) mit einer Plasmatemperatur kleiner 3000 K, insbesondere kleiner 2500 K, erzeugt wird, und wobei in die Spritzlanze (6) mit Hilfe eines Trägergases (T) ein Pulver (P) eingebracht wird, das vom Plasma (22) in Richtung zu einer stirnendseitigen Austrittsöffnung (16) der Spritzlanze (6) mitgeführt wird, dort austritt und auf das Substrat (4) auftrifft, **dadurch gekennzeichnet, dass** das ionisierbare Gas (G) sowie das Trägergas (T) unter dem gleichen Druck im Bereich von 1*10⁵ - 10*10⁵ Pa in die Spritzlanze (6) einströmen, wobei die Spritzlanze (6) einen unter einem Winkel (α), der zwischen 20° bis 70° liegt, schräg zur Längsrichtung (8) orientierten Zuführstutzen (18) für das Pulver (P) aufweist, und der Winkel (α), die Strömung des ionisierbaren Gases (G) sowie des Trägergases (T) derart aufeinander abgestimmt sind, dass das Pulver (P) vom Zuführstutzen (18) entlang einer bogenförmigen Bahn zur Austrittsöffnung (16) gelangt, ohne dass es in Kontakt mit Einrichtungen (12) oder Wandungen der Spritzlanze (6) kommt, und der Zuführstutzen (18) in Längsrichtung (8) 1 cm von der Austrittsöffnung (16) sowie im Bereich von 5 bis 7 cm von einer Kathode (12) der Spritzlanze (6) beabstandet ist.

2. Verfahren nach Anspruch 1,
bei dem die Spritzlanze (6) einen die Austrittsöffnung (16) aufweisenden Lanzenkopf (6A) umfasst, der nach Art einer einfachen, zur Austrittsöffnung (16) hin sich verjüngenden Düse ausgebildet ist, derart, dass das Trägergas (T) mit dem Pulver (P) maximal eine Geschwindigkeit unterhalb der Schallgeschwindigkeit erreicht.

3. Verfahren nach Anspruch 2,
bei dem der Lanzenkopf (6A) aus Glas besteht, bei der die die Austrittsöffnung (16) aufweisende Spitze auf ein definiertes Endmaß gezogen ist.

4. Verfahren nach Anspruch 3,
bei dem der Lanzenkopf (6A) auswechselbar befestigt ist, und mehrere Lanzenköpfe (6A) in einer Wechseleinheit (56) bevorratet sind, die in Abhängigkeit der gewünschten Bahnbreite automatisch ausgewählt und befestigt werden.

5. Verfahren nach einem der vorhergehenden Ansprüche,
bei dem die Spritzlanze (6) in einem Spritzabstand (a3) im Bereich zwischen 3 und 35 mm über das Substrat (4) verfahren wird.

6. Verfahren nach einem der vorhergehenden Ansprüche,
bei dem für das ionisierbare Gas (G) und das Trägergas (T) eine gleiche Gasquelle (48) herangezogen wird, über die der gemeinsame Druck für das Gas (G) sowie das Trägergas (T) vorgegeben wird, indem ein Gesamt-Gasvolumenstrom (G_{G}) in einen Volumenstrom für das der Spritzlanze (6) zugeführte Gas (G) und in einen Volumenstrom für das Trägergas (T) aufgezweigt wird.

7. Verfahren nach einem der vorhergehenden Ansprüche, insbesondere nach Anspruch 6,
bei dem das insbesondere abgezweigte Trägergas (T) durch eine Dosiervorrichtung (24) geleitet wird, um das Pulver (P) aufzunehmen.

8. Verfahren nach Anspruch 7,
bei dem die Dosiervorrichtung (24) einen Pulvervorratsbehälter (26) sowie eine Dosierkammer (28) umfasst, in die das Pulver (P) aus dem Pulvervorratsbehälter (26) unter Ausnutzung der Gravitationskraft über ein Dosierrohr (34) auf einen insbesondere rotierenden Dosierteller (40) dosiert wird und von diesem von einer Sauglanze (42) aufgenommen wird, indem das Trägergas (T) in die Dosierkammer (28) eingeleitet wird und in die Sauglanze (42) unter Mitreißen des Pulvers (10) einströmt.

9. Verfahren nach Anspruch 8,
bei dem der Pulvervorratsbehälter (26) mit dem Druck des Trägergases (T) beaufschlagt wird.

10. Verfahren nach einem der Ansprüche 7 bis 9,
bei dem dem Pulvervorratsbehälter (26) für einen kontinuierlichen Betrieb automatisch Pulver (P) zugeführt wird.

11. Verfahren nach einem der Ansprüche 7 bis 10,
bei dem mehrere mit unterschiedlichen Pulvern (P) gefüllte Vorratsbehälter (26) vorgesehen sind und die unterschiedlichen Pulver (P) in einem vorgegebenen Mischungsverhältnis der Spritzlanze (6) zugeführt werden.

12. Verfahren nach einem der vorhergehenden Ansprüche,
bei dem die Spritzlanze (6) bezüglich des Substrats (4) mit einer Relativgeschwindigkeit im Bereich von 10 cm/min bis 90 cm/min verfahren wird.

13. Vorrichtung zum Aufspritzen auf einer Bahn, insbesondere einer Leiterbahn (2), auf einem Substrat (4), umfassend eine sich in einer Längsrichtung (8) erstreckenden Spritzlanze (6), die mit einer Relativgeschwindigkeit relativ zu dem Substrat (4) verfahrbar ist, wobei der Spritzlanze (6) ein ionisierbares Gas (G) zuführbar ist, das durch einen in der Spritzlanze (6) erzeugbaren Lichtbogen (20) ionisierbar ist, so dass ein kaltes Plasma mit einer Plasmatemperatur kleiner 3000 K, insbesondere kleiner 2500 K, erzeugbar ist, und wobei in die Spritzlanze (6) mit Hilfe eines Trägergases (T) ein Pulver (P) zuführbar ist, das im Betrieb vom Plasma in Richtung zu einer stirnendseitigen Austrittsöffnung (16) der Spritzlanze (6) mitgeführt wird, dort austritt und auf das Substrat (4) auftrifft, **dadurch gekennzeichnet, dass** im Betrieb das ionisierbare Gas (G) sowie das Trägergas (T) unter dem gleichen Druck im Bereich von etwa 1*10⁵ - 10*10⁵ Pa in die Spritzlanze (6) einströmen, wobei hierzu für das ionisierbare Gas (G) und das Trägergas (T) eine gleiche Gasquelle (48) herangezogen ist, über die der gemeinsame Druck für das Gas (G) sowie das Trägergas (T) vorgegeben wird, indem ein Gesamt-Gasvolumenstrom (G_{G}) in einen Volumenstrom für das der Spritzlanze (6) zugeführte Gas (G) und in einen Volumenstrom für das Trägergas (T) aufgezweigt wird, wobei weiterhin die Spritzlanze (6) einen unter einem Winkel (α), der zwischen 20° bis 70° liegt, schräg zur Längsrichtung (8) orientierten Zuführstutzen (18) für das Pulver (P) aufweist, und der Winkel (α), die Strömung des ionisierbaren Gases (G) sowie des Trägergases (T) derart aufeinander abgestimmt sind, dass das Pulver (P) vom Zuführstutzen (18) entlang einer bogenförmigen Bahn zur Austrittsöffnung (16) gelangt, ohne dass es in Kontakt mit Einrichtungen (12) oder Wandungen der Spritzlanze (6) kommt, und wobei der Zuführstutzen (18) in Längsrichtung (8) 1 cm von der Austrittsöffnung (26) sowie im Bereich von 5 bis 7 cm von einer Kathode (12) der Spritzlanze (6) beabstandet ist.

## Claims

1. Method for spraying a track, in particular a conductor track (2), onto a substrate (4) by means of a spray lance (6) extending in a longitudinal direction (8), said spray lance (6) being moved with a relative speed relative to the substrate (4), wherein an ionisable gas (G) is supplied to the spray lance (6) under atmospheric conditions, said gas (G) being ionised by an arc (20) produced in the spray lance (6) such that a cold plasma (22) having a plasma temperature of less than 3000 K, in particular less than 2500 K, is produced, and wherein a powder (P) is introduced into the spray lance (6) by means of a carrier gas (T), said powder (P) being carried along by the plasma (22) in the direction of a frontal exit opening (16) of the spray lance (6), exiting here and appearing on the substrate (4), **characterised in that** the ionisable gas (G) and the carrier gas (T) flow into the spray lance (6) under the same pressure ranging from 1*10⁵ - 10*10⁵ Pa, wherein the spray lance (6) has a feed connector (18) for the powder (P) that is orientated at an angle (α) that lies between 20° to 70°, at an incline relative to the longitudinal direction (8), and the angle (α), the flow of the ionisable gas (G) and the carrier gas (T) coordinate with one another in such a way that the powder (P) passes from the feed connector (18) along an arcuate track to the exit opening (16) without it coming into contact with devices (12) or walls of the spray lance (6), and the feed connector (18) is spaced 1 cm in the longitudinal direction (8) away from the exit opening (16) and in the range from 5 to 7cm away from a cathode (12) of the spray lance (6).

2. Method according to claim 1,
in which the spray lance (6) comprises a lance head (6A) having the exit opening (16), said lance head being formed as a simple nozzle tapering towards the exit opening (16) in such a way that the carrier gas (T) with the powder (P) reaches a maximum speed below the speed of sound.

3. Method according to claim 2,
in which the lance head (6A) consists of glass, wherein the tip having the exit opening (16) is drawn to a defined end dimension.

4. Method according to claim 3,
in which the lance head (6A) is interchangeably fixed, and several lance heads (6A) are stored in a changer unit (56), said lance heads being automatically selected depending on the desired track width and fixed.

5. Method according to one of the preceding claims,
in which the spray lance (6) is moved across the substrate (4) at a spraying distance (a3) ranging between 3 and 35mm,

6. Method according to one of the preceding claims,
in which the same gas source (48) is used for the ionisable gas (G) and the carrier gas (T), via which gas source (48) the common pressure for the gas (G) and carrier gas (T) is predetermined by branching a total gas volumetric flow (G_{G}) into a volumetric flow for the gas (G) supplied to the spray lance (6) and into a volumetric flow for the carrier gas (T).

7. Method according to one of the preceding claims, in particular according to claim 6, in which, in particular, the branched-off carrier gas (T) is conducted through a metering device (24) in order to receive the powder (P).

8. Method according to claim 7,
in which the metering device (24) comprises a powder storage container (26) and a metering chamber (28) in which the powder (P) from the powder storage container (26) is metered by exerting a gravitational force via a metering tube (34) onto an in particular rotating metering plate (40) and is received from this by a suction lance (42) by the carrier gas (T) being introduced into the metering chamber (28) and flowing into the suction lance (42) entraining the powder (10).

9. Method according to claim 8,
in which the powder storage chamber (26) is supplied with the pressure of the carrier gas (T).

10. Method according to one of claims 7 to 9,
in which powder (P) is automatically supplied to the powder storage chamber (26) for a continuous operation.

11. Method according to one of claims 7 to 10,
in which several storage chambers (26) filled with different powders (P) are provided and the different powders (P) are supplied to the spray lance (6) in a predetermined mixture ratio.

12. Method according to one of the preceding claims,
in which the spray lance (6) is moved relative to the substrate (4) with a relative speed ranging from 10cm/min to 90cm/min.

13. Device for spraying a track, in particular a conductor track (2), on a substrate (4), comprising a spray lance (6) extending in a longitudinal direction (8), said spray lance (6) being able to be moved with a relative speed relative to the substrate (4), wherein an ionisable gas (G) is able to be supplied to the spray lance (6), said gas (G) being able to be ionised by an arc (20) produced in the spray lance (6) such that a cold plasma having a plasma temperature of less than 3000 K, in particular af less than 2500 K, is produced, and wherein a powder (P) is able to be supplied into the spray lance (6) by means of a carrier gas (T), said powder (P) being carried along during operation by the plasma in the direction of a frontal exit opening (16) of the spray lance (6), exiting here and appearing on the substrate (4), **characterised in that**, during operation, the ionisable gas (G) and the carrier gas (T) flow into the spray lance (6) under the same pressure ranging from around 1*10⁵ - 10*10⁵ Pa, wherein the same gas source (48) is used for the ionisable gas (G) and the carrier gas (T), via which gas source (48) the common pressure for the gas (G) and carrier gas (T) is predetermined by branching a total gas volumetric flow (G_{G}) into a volumetric flow for the gas (G) supplied to the spray lance (6) and into a volumetric flow for the carrier gas (T), wherein furthermore the spray lance (6) has a feed connector (18) for the powder (P) that is orientated at an angle (α) that lies between 20° to 70°, at an incline relative to the longitudinal direction (8), and the angle (α), the flow of the ionisable gas (G) and the carrier gas (T) coordinate with one another in such a way that the powder (P) passes from the feed connector (18) along an arcuate track to the exit opening (16) without it coming into contact with devices (12) or walls of the spray lance (6), and wherein the feed connector (18) is spaced 1cm in the longitudinal direction (8) away from the exit opening (16) and in the range from 5 to 7cm away from a cathode (12) of the spray lance (6).

## Revendications

1. Procédé destiné à appliquer une piste par pulvérisation, notamment une piste conductrice (2), sur un substrat (4), à l'aide d'une lance de pulvérisation (6) qui s'étend dans une direction longitudinale (8), et est déplacée avec une vitesse relative par rapport au substrat (4), procédé
d'après lequel la lance de pulvérisation (6) est alimentée sous conditions atmosphériques en un gaz (G) pouvant être ionisé, qui va être ionisé par un arc électrique (20) produit dans la lance de pulvérisation (6), de manière à engendrer un plasma froid (22) avec une température de plasma inférieure à 3000 K, notamment inférieure à 2500 K, et
d'après lequel on introduit dans la lance de pulvérisation (6), à l'aide d'un gaz porteur (T), une poudre (P), qui est entraînée par le plasma (22) en direction d'une ouverture de sortie (16) à l'extrémité frontale de la lance de pulvérisation (6), et sort au niveau de cette ouverture pour venir frapper le substrat (4),
**caractérisé en ce que** le gaz (G) pouvant être ionisé, ainsi que le gaz porteur (T), pénètrent en s'écoulant à l'intérieur de la lance de pulvérisation (6), sous une même pression située dans une plage 1*10⁵ - 10*10⁵ Pa, **en ce que** la lance de pulvérisation (6) comporte un embout d'alimentation (18) pour la poudre (P), qui est orienté de manière inclinée par rapport à la direction longitudinale (8) sous un angle (α) situé entre 20° et jusqu'à 70°, et l'angle (α), l'écoulement du gaz (G) pouvant être ionisé ainsi que du gaz porteur (T), sont adaptés réciproquement les uns aux autres de manière à ce que la poudre (P) parvienne de l'embout d'alimentation (18) à l'ouverture de sortie (16), le long d'une trajectoire en forme d'arc, sans entrer en contact avec des dispositifs (12) ou des parois de la lance de pulvérisation (6), et **en ce que** l'embout d'alimentation (18) est situé, dans la direction longitudinale (8), à une distance de 1 cm de l'ouverture de sortie (16), ainsi qu'à une distance, dans une plage de 5 à 7 cm, d'une cathode (12) de la lance de pulvérisation (6).

2. Procédé selon la revendication 1,
d'après lequel la lance de pulvérisation (6) comprend une tête de lance (6A) présentant l'ouverture de sortie (16) et qui est réalisée à la manière d'une simple buse se rétrécissant en direction de l'ouverture de sortie (16), de manière telle que le gaz porteur (T) avec la poudre (P) atteigne au maximum une vitesse en-dessous de la vitesse du son.

3. Procédé selon la revendication 2,
d'après lequel la tête de lance (6A) est réalisée en verre, dont la pointe présentant l'ouverture de sortie (16) est étirée à une dimension finale définie.

4. Procédé selon la revendication 3,
d'après lequel la tête de lance (6A) est fixée de manière interchangeable, et plusieurs têtes de lance (6A) sont stockées en réserve dans une unité d'échange (56), et sont sélectionnées et fixées automatiquement en fonction de la largeur de piste souhaitée.

5. Procédé selon l'une des revendications précédentes, d'après lequel la lance de pulvérisation (6) est déplacée à une distance de pulvérisation (a3) dans une plage entre 3 et 35 mm, au-dessus du substrat (4).

6. Procédé selon l'une des revendications précédentes, d'après lequel on utilise pour le gaz (G) pouvant être ionisé et le gaz porteur (T), une même source de gaz (48), qui prédétermine la pression commune pour le gaz (G) ainsi que pour le gaz porteur (T), en produisant une division d'un débit-volume de gaz global (G_{G}) en un débit-volume pour le gaz (G) amené à la lance de pulvérisation (6) et un débit-volume pour le gaz porteur (T).

7. Procédé selon l'une des revendications précédentes, notamment selon la revendication 6,
d'après lequel le gaz porteur (T) notamment dérivé par la division, est dirigé dans un dispositif de dosage (24) en vue d'y absorber la poudre (P).

8. Procédé selon la revendication 7,
d'après lequel le dispositif de dosage (24) comprend un réservoir de poudre (26) ainsi qu'une chambre de dosage (28) dans laquelle la poudre (P) en provenance du réservoir de poudre (26) est dosée sur une coupelle de dosage (40), notamment rotative, par l'intermédiaire d'un tube de dosage (34) et en utilisant la force de gravitation, la poudre étant ensuite prélevée par une lance d'aspiration (42) grâce au fait que le gaz porteur (T) est introduit dans la chambre de dosage (28) et s'écoule ensuite dans la lance d'aspiration (42) en entraînant la poudre (10).

9. Procédé selon la revendication 8,
d'après lequel le réservoir de poudre (26) est alimenté avec la pression du gaz porteur (T).

10. Procédé selon l'une des revendications 7 à 9,
d'après lequel de la poudre (P) est amenée automatiquement au réservoir de poudre (26) pour assurer un fonctionnement continu.

11. Procédé selon l'une des revendications 7 à 10, d'après lequel sont prévus plusieurs réservoir de poudre (26) remplis de poudres (P) différentes, et les différentes poudres (P) sont amenées selon une proportion de mélange prédéterminée à la lance de pulvérisation (6).

12. Procédé selon l'une des revendications précédentes, d'après lequel la lance de pulvérisation (6) est déplacée par rapport au substrat (4) avec une vitesse relative se situant dans une plage de 10cm/min, à 90 cm/min.

13. Installation destinée à appliquer une piste par pulvérisation, notamment une piste conductrice (2), sur un substrat (4), comprenant une lance de pulvérisation (6) s'étendant dans une direction longitudinale (8) et pouvant être déplacée avec une vitesse relative par rapport au substrat (4), installation
dans laquelle la lance de pulvérisation (6) peut être alimentée en un gaz (G) pouvant être ionisé, qui peut être ionisé par un arc électrique (20) produit dans la lance de pulvérisation (6), de manière à pouvoir engendrer un plasma froid avec une température de plasma inférieure à 3000 K, notamment inférieure à 2500 K, et dans laquelle il est possible d'introduire dans la lance de pulvérisation (6), à l'aide d'un gaz porteur (T), une poudre (P), qui est entraînée par le plasma en direction d'une ouverture de sortie (16) à l'extrémité frontale de la lance de pulvérisation (6), et qui sort au niveau de cette ouverture pour venir frapper le substrat (4),
**caractérisée en ce qu'**en fonctionnement, le gaz (G) pouvant être ionisé, ainsi que le gaz porteur (T), pénètrent en s'écoulant à l'intérieur de la lance de pulvérisation (6) sous une même pression située dans une plage 1*10⁵ - 10*10⁵ Pa, **en ce qu'**à cet effet on utilise pour le gaz (G) pouvant être ionisé et le gaz porteur (T), une même source de gaz (48), qui prédétermine la pression commune pour le gaz (G) ainsi que pour le gaz porteur (T), en produisant une division d'un débit-volume de gaz global (G_{G}) en un débit-volume pour le gaz (G) amené à la lance de pulvérisation (6) et un débit-volume pour le gaz porteur (T), **en ce que** la lance de pulvérisation (6) comporte par ailleurs un embout d'alimentation (18) pour la poudre (P), qui est orienté de manière inclinée par rapport à la direction longitudinale (8) sous une angle (α) situé entre 20° et jusqu'à 70°, et l'angle (α), l'écoulement du gaz (G) pouvant être ionisé ainsi que du gaz porteur (T), sont adaptés réciproquement les uns aux autres de manière à ce que la poudre (P) parvienne de l'embout d'alimentatian (18) à l'ouverture de sortie (16) le long d'une trajectoire en forme d'arc, sans entrer en contact avec des dispositifs (12) ou des parois de la lance de pulvérisation (6), et **en ce que** l'embout d'alimentation (18) est situé, dans la direction longitudinale (8), à une distance de 1 cm de l'ouverture de sortie (16), ainsi qu'à une distance, dans une plage de 5 à 7 cm, d'une cathode (12) de la lance de pulvérisation (6).
